Europäisches Patentamt

European Patent Office

Office européen des brevets

(19)

(11) **EP 0 604 295 B1**

(12) **FASCICULE DE BREVET EUROPEEN**

(45) Date de publication et mention
de la délivrance du brevet:
**26.11.1997 Bulletin 1997/48**

(51) Int Cl.6: **H03G 3/20**

(21) Numéro de dépôt: **93403103.0**

(22) Date de dépôt: **20.12.1993**

(54) **Procédé de contrôle automatique de gain pour un récepteur numérique, notamment un récepteur à accès multiple à répartition dans le temps et dispositif pour sa mise en oeuvre**

Verfahren zur Verstärkungsregelung in einem digitalen Empfänger, insbesondere einem TDMA-Empfänger und Vorrichtung zur Durchführung des Verfahrens

A method for automatic gain control of a digital receiver, in particular in a TDMA receiver and a device for performing the method

(84) Etats contractants désignés:
**AT BE CH DE ES FR GB IT LI NL SE**

(30) Priorité: **23.12.1992 FR 9215615**

(43) Date de publication de la demande:
**29.06.1994 Bulletin 1994/26**

(72) Inventeur: **Gourgue, Frederic**
**F-75017 Paris (FR)**

(74) Mandataire:
**Pothet, Jean Rémy Emile Ludovic et al**
**ALCATEL ALSTHOM,**
**Département de Propriété Industrielle,**
**30, avenue Kléber**
**75116 Paris (FR)**

(73) Titulaire: **ALCATEL ALSTHOM COMPAGNIE
GENERALE D'ELECTRICITE**
**75008 Paris (FR)**

(56) Documents cités:
**EP-A- 0 455 388        WO-A-90/06644
US-A- 5 161 170**

**Description**

La présente invention concerne un procédé de contrôle automatique de gain pour un récepteur numérique, notamment un récepteur à accès multiple à répartition dans le temps (AMRT).

Les trames numériques reçues sont composées de paquets de données émis à tour de rôles par un ensemble d'émetteurs plus ou moins distants. Or, deux paquets successifs peuvent présenter un écart de niveau important à la réception, par exemple 90 dB. Le gain de l'amplificateur de réception doit être réglé pour amener le niveau du signal dans la dynamique de la chaine de traitement qui suit l'amplificateur.

Un paquet de données comprend à titre d'exemple :

- une rampe de montée en puissance avec possibilité d'une légère sur-oscillation, d'une durée de 28 μs ;
- une période durant laquelle la puissance est constante, d'une durée de 542,8 μs durant laquelle l'information est transmise. Cette période sera dénommée "période utile" par la suite; et
- une rampe de baisse de puissance d'une durée de 28 μs.

La rampe de baisse de puissance d'un paquet de données peut partiellement chevaucher la rampe de montée en puissance du paquet suivant. Cependant, le gain de la chaine de réception doit être ajusté à l'arrivée de chaque paquet de données afin de ramener le niveau du signal durant la période utile dans la dynamique de chaine de traitement située en aval du récepteur. Ce gain doit rester constant durant la réception de la période utile afin d'optimiser le fonctionnement des traitements en bande de base.

Jusqu'à présent, pour palier à ce problème, une première solution consistait à avoir plusieurs amplificateurs de réception présentant des gains différents et travaillant en parallèle. La sortie de chacun de ces amplificateurs était échantillonnée puis mémorisée et un organe de sélection venait choisir le meilleur résultat mémorisé. Une autre solution consistait à employer une ligne à retard suivie d'un amplificateur commandé par un dispositif prélevant le signal reçu en amont de la ligne à retard, analysant la puissance de ce signal et ajustant le gain de l'amplificateur afin d'amplifier convenablement ce même signal à la sortie de la ligne à retard.

Or la technique de sélection qui suppose la mise en oeuvre de plusieurs amplificateurs est une solution coûteuse. Par ailleurs, l'utilisation d'une ligne à retard suivie d'un amplificateur conduit à une génération de bruit et à un retard.

Le but de la présente invention est de remédier à ces inconvénients en proposant un procédé de contrôle automatique de gain qui n'induise ni bruit ni retard tout en étant moins coûteux que les procédés existants.

Suivant l'invention, le procédé de contrôle automatique de gain pour un récepteur numérique, notamment un récepteur numérique à accès multiple à répartition dans le temps (AMRT), ce récepteur comprenant des moyens amplificateurs de gain réglable recevant un signal d'entrée, est caractérisé en ce qu'il comprend les étapes suivantes:

- un échantillonnage à une fréquence d'échantillonnage prédéterminée du signal de sortie desdits moyens amplificateurs ;
- un traitement des échantillons obtenus comportant, pour chaque échantillon, une comparaison de la valeur absolue de cet échantillon respectivement à un seuil maximum et à un seuil minimum prédéterminés associés respectivement à une fourchette maximum [-SMAX, +SMAX] et une fourchette minimum [-SMIN, +SMIN] et
- un réglage du gain des moyens amplificateurs effectué à l'issue de chaque traitement d'échantillon, de sorte que:

   * si un échantillon est en dehors de la fourchette maximum [-SMAX, +SMAX], ce gain est réduit d'un niveau de réduction prédéterminé ;
   * si plusieurs échantillons successifs en nombre prédéterminé sont compris dans la fourchette minimum [-SMIN, +SMIN], ce gain est augmenté d'un niveau d'augmentation prédéterminé.

Selon un premier mode de mise en oeuvre du procédé selon l'invention, chaque échantillon est comparé à quatre seuils: un seuil maximum et un seuil minimum et leurs valeurs opposées respectives.

Selon un second mode de mise en oeuvre du procédé selon l'invention, la valeur absolue de chaque échantillon est déterminée puis comparée au seuil maximum et au seuil minimum.

Suivant un autre aspect de l'invention, le dispositif de contrôle automatique de gain pour un récepteur numérique, notamment un récepteur numérique à accès multiple à répartition dans le temps (AMRT),ce récepteur comprenant des moyens amplificateurs de gain réglable recevant un signal d'entrée, mettant en oeuvre le procédé selon l'invention, est caractérisé en ce qu'il comprend des moyens pour échantillonner à une fréquence d'échantillonnage prédéterminée le signal de sortie desdits moyens amplificateurs, des moyens pour comparer la valeur absolue de chaque échantillon obtenu respectivement à un seuil maximum et à un seuil minimum et pour générer des informations de détection de seuil, et des moyens pour régler le gain des moyens amplificateurs coopérant avec les moyens de comparaison pour réduire d'un niveau de réduction prédéterminé ledit gain dès que l'échantillon est détecté en dehors de la fourchette maximum [-SMAX, +SMAX], et pour augmenter d'un niveau d'augmentation prédéterminé ledit gain dès que plusieurs échantillons en nombre prédéterminé sont compris dans la fourchette minimum [-SMIN, +SMIN].

Ainsi, la présente invention présente l'avantage de permettre une intégration du dispositif de contrôle automatique de gain dans un circuit intégré et de faire appel à un détecteur très simple pour la boucle de contre-réaction. En outre, la stabilité du système est accrue par la logique de contrôle mise en oeuvre avec le procédé selon l'invention. De plus, on obtient dans le GSM une correction de 90 dB pendant une période bit et le procédé selon l'invention opère en tension et non en puissance, ce qui contribue à améliorer la rapidité du contrôle automatique de gain.

D'autres particularités et avantages de l'invention apparaîtront encore dans la description ci-après. Aux dessins annexés donnés à titre d'exemples non limitatifs:

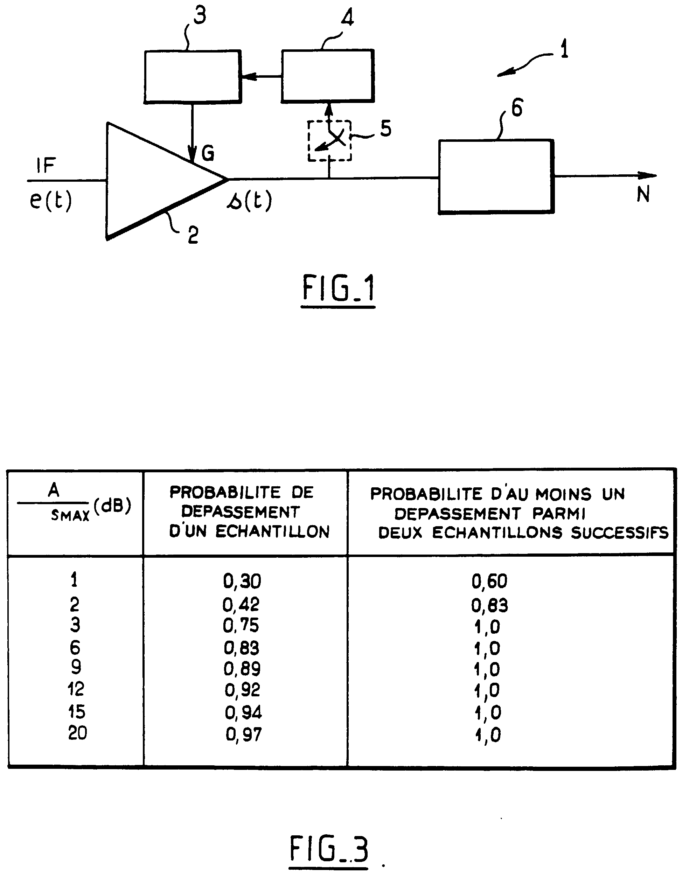

- la figure 1 est un schéma synoptique illustrant un dispositif de contrôle automatique de gain selon l'invention ;
- la figure 2A est un chronogramme correspondant au cas où le niveau initial du signal est supérieur au seuil maximum ;
- la figure 2B est un chronogramme correspondant au cas où le niveau initial du signal est inférieur à un seuil minimum ; et
- la figure 3 est un tableau donnant les probabilités respectives de dépassement d'un échantillon et d'au moins un dépassement parmi deux échantillons successifs nécessaires pour le réglage de l'algorithme et de la fréquence d'échantillonnage mettant en oeuvre le procédé selon l'invention dans le cas d'un signal d'entrée sinusoïdal d'amplitude A.

On va maintenant décrire un exemple de mise en oeuvre du procédé selon l'invention en même temps que le dispositif associé.

Au sein d'un dispositif de contrôle automatique de gain 1 selon l'invention, un amplificateur 2 qui travaille en fréquence intermédiaire (IF) reçoit un signal analogique e(t) sous la forme d'une succession de paquets de données et est suivi en sortie d'un détecteur 4 d'amplitude du signal à deux seuils (minimum et maximum) en entrée du quel est placé un échantillonneur 5. Un convertisseur analogique /numérique 6 est également placé en sortie de l'amplificateur 2 pour délivrer un ensemble de données numérisées N qui sont soumises à un traitement en aval. Les échantillons recueillis en sortie du détecteur 4 alimentent un dispositif logique de contrôle 3 qui régule le gain de l'amplificateur 2 de façon à prévenir tout risque d'oscillation.

A titre d'exemple, un algorithme de contrôle matérialisant le procédé selon l'invention et implémenté au sein du dispositif logique de contrôle 3 peut comprendre les étapes suivantes:

- si la valeur absolue d'un échantillon dépasse un seuil maximum SMAX, à savoir si cet échantillon est en dehors de la fourchette [-SMAX, +SMAX], le gain est diminué de 3 dB ;
- si deux échantillons successifs sont compris dans la fourchette minimum [-SMIN, +SMIN], le gain est augmenté de 3 dB.

Le signal e(t) en entrée de l'amplificateur 2 peut être modélisé sous la forme suivante:

- $e(t)=A(t).\sin[\omega_0 t+\varphi(t)]$ ;
  où:
      A(t) est conforme à des masques de puissance prédéterminés, notamment des masques prescrits dans une recommandation technique telle "GSM 05.05" ;
- $\omega_0$ est la pulsation de la fréquence intermédiaire IF ; et
- $\varphi(t)$ est la phase modulée par le flux de données.

A titre d'exemple d'une réalisation pratique de l'invention, les variations de A(t) sont lentes, par exemple, moins de 0.4 dB entre deux échantillons, et la fréquence intermédiaire peut par exemple être égale à 9.75 MHz.

L'échantillonneur 5 opère à une fréquence Fe de 13 MHz, à savoir 48 fois la fréquence symbole, dans le cas du GSM. les échantillons en sortie sont du type:

- $u(kTe)=\sin[\omega_0 kTe+\varphi(kTe)]$.

Comme la phase $\varphi(t)$ varie d'au plus $\pi/2$ entre deux symboles dans le cas du GSM, elle variera de moins de $\pi/96$ entre deux échantillons. La variation de phase due à la fréquence porteuse est par contre beaucoup plus importante, puisqu'elle est égale à $\omega_0/Fe$, soit $1.5\pi$.

La variation de phase entre deux échantillons successifs est (en prenant les échantillons k et k+1 à titre d'exemple):

$$\omega_0 Te + \varphi((k+1)Te)-\varphi((k-1)Te)$$

On observe qu'elle se décompose en deux termes:

- variation due à la fréquence intermédiaire: $\omega_0 Te$, c'est à dire, $\omega_0/Fe$ ;
- variation due à la modification par le flux de données: $\varphi((k+1)Te)-\varphi((k-1)Te)$.

La fréquence d'échantillonnage Fe et la fréquence intermédiaire (de pulsation $\omega_0$ ) sont choisies afin que le rapport $\omega_0/Fe$ soit un multiple impair de $\pi/2$.

La fréquence d'échantillonnage Fe est de plus choisie très supérieure à la fréquence symbole du signal reçu en entrée afin que la variation de phase due à la modulation par le flux de données entre deux échantillons successifs soit négligeable par rapport à $\pi/2$.

Il est de plus souhaitable que la fréquence d'échantillonnage Fe soit choisie suffisamment grande pour que l'amplitude A(t) du signal tel que défini ci-dessus varie lentement entre deux échantillons.

Le détecteur de seuil 4 évalue la valeur absolue de l'amplitude de chaque échantillon par rapport à deux seuils:

- un seuil maximum, placé par exemple à 6 dB sous le niveau de saturation de la partie bande de base du récepteur, sert à détecter les signaux trop forts, donc les gains de l'amplificateur 2 trop élevés ;
- un seuil minimum SMIN, placé par exemple à 10 dB sous le seuil maximum, sert à déterminer si le signal a une amplitude insuffisante, donc si le gain de l'amplificateur 2 est trop faible.

Le dispositif logique de contrôle 3 interprète les informations provenant du détecteur 4 pour ajuster le gain de l'amplificateur 2 tout en assurant la stabilité de la boucle, selon l'algorithme suivant:

- si la valeur absolue d'un échantillon dépasse le seuil maximum, le gain est réduit de 3 dB ;
- si la valeur absolue de deux échantillons successifs est inférieure au seuil minimum, le gain est augmenté de 3 dB ;
- sinon, le gain est maintenu inchangé.

On va maintenant décrire un exemple de simulation de l'algorithme précité dans le cas d'un signal sinusoïdal en entrée: $e(t) = A.\sin(\omega_0 t + \varphi)$, en prenant en compte les différentes situations de détection possibles.

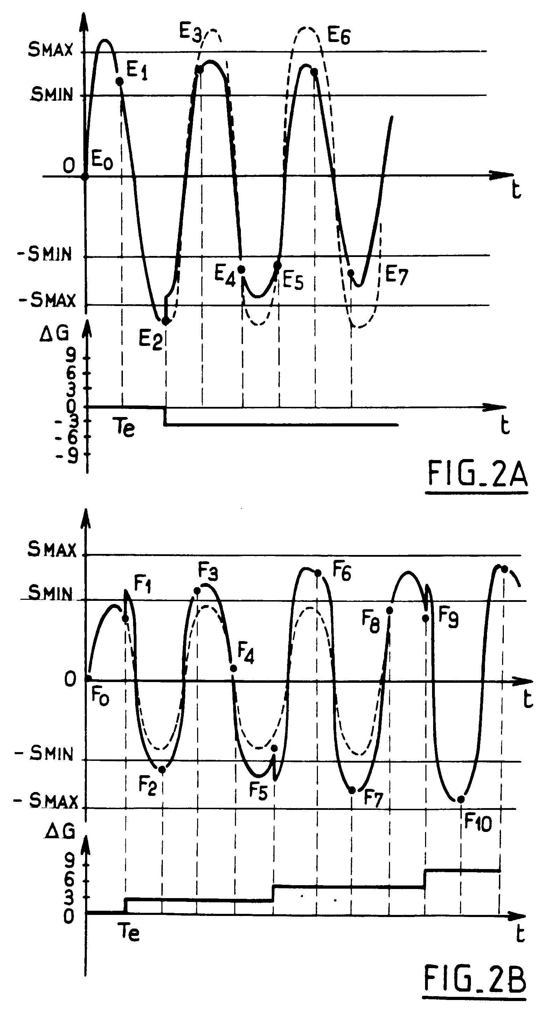

Si, en référence à la figure 2A, le niveau initial du signal est supérieur au seuil maximum SMAX, la probabilité d'un dépassement de seuil en fonction du rapport entre la tension crête A et le seuil maximum est donnée par le tableau de la figure 3. Les valeurs de probabilité indiquées dans ce tableau sont optimales du rapport entre la fréquence porteuse et la fréquence d'échantillonnage qui permet à la phase de tourner d'un angle $\pi/2$ (modulo $\pi$) entre deux échantillons.

Par conséquent, à une valeur de $|\sin[(\omega_0 kT)]|$ proche de 0, correspond une valeur de $|\sin[(\omega_0(k+1)T)]|$ proche de 1, expliquant les très fortes probabilités en dernière colonne du tableau. Il faut noter qu'une valeur élevée de la fréquence d'échantillonnage a pour effet de rendre négligeable le déphasage entre deux échantillons par rapport au déphasage de $\pi/2$ dû à la porteuse. De plus, les variations de l'amplitude A(t) entre deux échantillons sont également négligeables.

Dans l'exemple illustré en figure 2A, correspondant à une fréquence porteuse de 9.75 MHz et une fréquence d'échantillonnage de 13 MHz, on suppose qu'à l'instant initial t=0, le gain G de l'amplificateur 2 est tel que l'amplitude du signal de sortie est supérieure à SMAX et que le premier échantillon prélevé E0 est presque nul, à titre d'exemple non limitatif. A l'instant t=Te, l'échantillon E1 est compris entre les seuils SMIN et SMAX et le gain de l'amplificateur 2 reste inchangé (variation de gain $\Delta G = 0$). A l'instant t=2Te, l'échantillon E2 est de module supérieur à SMAX, ce qui provoque une réduction de 3 dB du gain de l'amplificateur 2, et par conséquent une réduction de l'amplitude du signal de sortie. L'échantillon E3 est compris entre le seuil minimum SMIN et le seuil maximum SMAX. Le gain reste donc inchangé. Les échantillons suivants E4, E5, E6, E7 sont également compris en valeur absolue dans la fourchette SMIN-SMAX. Il peut arriver qu'un échantillon tombe dans la fourchette [-SMIN, +SMIN], mais cela ne peut jamais être le cas pour deux échantillons successifs. Le gain G reste dès lors constant pour toute la durée du paquet.

Si, en référence à la figure 2B, le niveau initial du signal est inférieur au seuil minimum SMIN, le premier échantillon F0 va être bien sûr situé dans la fourchette [-SMIN, +SMIN], mais le dispositif de contrôle automatique de gain selon l'invention ne va pas réagir pour des raisons de stabilité. Si le deuxième échantillon F1 est également compris dans la fourchette [-SMIN, +SMIN], le gain G est alors accru de 3 dB pour chaque nouvel échantillon F1 sous le seuil minimum SMIN. Lorsque la valeur absolue d'un échantillon franchit le seuil minimum SMIN, comme c'est le cas des échantillons F2 et F3, la croissance du gain G va être arrêtée. Deux cas sont alors possibles:

- si la valeur crête du signal reçu est juste au dessus du seuil minimum SMIN, alors les valeurs absolues de deux échantillons successifs vont passer sous le seuil avec une très forte probabilité, comme c'est le cas des deux échantillons successifs F4 et F5, et le gain G de l'amplificateur 2 est alors accru de 3 dB supplémentaires ;
- si le signal est déjà bien au dessus du seuil minimum SMIN, par exemple d'au moins 3 dB, le gain de l'amplificateur 2 est maintenu constant.

Dans le cas illustré en figure 2B, un troisième ajustement du gain de l'amplificateur 2 est encore nécessaire pour obtenir une stabilisation convenable de l'amplitude du signal de sortie, puisque les valeurs absolues de deux échantillons successifs F8, F9 sont inférieures au seuil minimum SMIN.

Si le niveau initial du signal est compris entre les deux seuils minimum SMIN et maximum SMAX, la probabilité de dépassement du seuil maximum est nulle, et la probabilité de passer sous le seuil minimum est donnée par le tableau de la figure 3. Si la valeur crête du signal dépasse de 3 dB au moins le seuil minimum SMIN, le gain ne va pas varier car la probabilité que les valeurs absolues de deux échantillons successifs soient sous le seuil est nulle. Si la valeur crête est supérieure au seuil minimum SMIN de moins de 3 dB, il est possible que les valeurs absolues de deux échantillons successifs soient sous le seuil, ce qui entraîne avec le procédé selon l'invention un accroissement du gain de 3 dB, entraînant le système dans une zone stable.

Les résultats de simulation présentés ci-dessus démontrent que le procédé de contrôle automatique de gain selon l'invention permet de récupérer une variation de niveau sans induire de retard significatif. On peut ainsi obtenir une correction d'un saut de puissance de 90 dB sur une durée de réception d'un bit.

Bien sûr, l'invention n'est pas limitée aux exemples qui viennent d'être décrits et de nombreux aménagements peuvent être apportés à ces exemples sans sortir du cadre de l'invention.

Ainsi, les valeurs de seuil minimum et maximum précitées ont été données uniquement à titre d'exemple pratique, mais peuvent être choisies en fonction des contraintes spécifiques au récepteur concerné. De plus, le nombre d'échantillons successifs sous le seuil minimum avant une augmentation de gain de l'amplificateur peut être supérieur à 2. Par ailleurs, le nombre de seuils de détection et comparaison peut être augmenté de la valeur des pas de réglage de l'amplificateur, afin d'obtenir plusieurs modes, tels qu'un mode de rattrapage et un mode de poursuite. On peut également prévoir d'autres rapports entre la fréquence porteuse et la fréquence d'échantillonnage ou entre la fréquence bit et la fréquence d'échantillonnage.

Le procédé de contrôle automatique de gain selon l'invention peut être avantageusement mis en oeuvre dans un récepteur pour les systèmes GSM et TETRA.

**Revendications**

1. Procédé de contrôle automatique de gain pour un récepteur numérique (1), notamment un récepteur numérique à accès multiple à répartition dans le temps (AMRT),ce récepteur comprenant des moyens amplificateurs de gain réglable (2) recevant un signal d'entrée (e(t)), caractérisé en ce qu'il comprend les étapes suivantes:

   - un échantillonnage à une fréquence d'échantillonnage prédéterminée du signal de sortie (s(t)) desdits moyens amplificateurs (2),
   - un traitement des échantillons obtenus comportant, pour chaque échantillon, une comparaison de la valeur absolue de cet échantillon respectivement à un seuil maximum (SMAX) et à un seuil minimum (SMIN) prédéterminés associés respectivement à une fourchette maximum [-SMAX, +SMAX] et une fourchette minimum [-SMIN, +SMIN] et
   - un réglage du gain (G) des moyens amplificateurs (2) effectué à l'issue de chaque traitement d'échantillon, de sorte que:

      * si un échantillon (E2) est en dehors de la fourchette maximum [-SMAX, +SMAX], ce gain (G) est réduit d'un niveau de réduction prédéterminé ;
      * si plusieurs échantillons successifs (F0, F1;F4, F5;F8, F9) en nombre prédéterminé sont compris dans la fourchette minimum [-SMIN, +SMIN], ce gain (G) est augmenté d'un niveau d'augmentation prédéterminé.

2. Procédé selon la revendication 1, caractérisé en ce que chaque échantillon est comparé à quatre seuils: un seuil maximum et un seuil minimum et leurs valeurs opposées respectives.

3. Procédé selon la revendication 1, caractérisé en ce que la valeur absolue de chaque échantillon est déterminée puis comparée au seuil maximum et au seuil minimum.

4. Procédé selon l'une quelconque des revendications 1 à 3, caractérisé en ce que le nombre prédéterminé d'échantillons successifs compris dans la fourchette minimum [-SMIN, +SMIN] conduisant à une augmentation du gain est égal à 2.

5. Dispositif (3, 4, 5) de contrôle automatique de gain pour un récepteur numérique (1), notamment un récepteur numérique à accès multiple à répartition dans le temps (AMRT),ce récepteur (1) comprenant des moyens amplificateurs de gain réglable (2) recevant un signal d'entrée (e(t)), mettant en oeuvre le procédé selon l'une quelconque des revendications précédentes, caractérisé en ce qu'il comprend des moyens (5) pour échantillonner à une fréquence d'échantillonnage (Fe) prédéterminée le signal de sortie (s(t)) desdits moyens amplificateurs (2), des moyens (4) pour comparer la valeur absolue de chaque échantillon obtenu respectivement à un seuil maximum (SMAX)et à un seuil minimum (SMIN) et pour générer des informations de détection de seuil, et des moyens (3) pour régler le gain (G) des moyens amplificateurs (2), ces moyens de réglage (3) coopérant avec les moyens de comparaison (4) pour réduire d'un niveau de réduction prédéterminé ledit gain (G) dès qu'un échantillon (E2) est détectée en dehors d'une fourchette maximum [-SMAX, +SMAX], et pour augmenter d'un niveau d'augmentation prédéterminé ledit gain (G) dès que plusieurs échantillons successifs (F0, F1;F4, F5; F8, F9) en nombre prédéterminé sont compris dans une fourchette minimum [-SMIN, +SMIN].

6. Dispositif (3, 4, 5) selon la revendication 5, caractérisé en ce que les niveaux de réduction et d'augmentation de gain sont sensiblement égaux à 3 dB.

7. Dispositif (3, 4, 5) selon l'une quelconque des revendications 5 ou 6, caractérisé en ce que le seuil minimum (SMIN) est placé à sensiblement 10 dB en dessous du seuil maximum (SMAX).

8. Dispositif (3, 4, 5) selon l'une quelconque des revendications 5 à 7, caractérisé en ce que le seuil maximum (SMAX) est placé à sensiblement 6 dB en dessous du niveau de saturation de la partie bande de base du récepteur (1).

9. Dispositif (3, 4, 5) selon l'une quelconque des revendications 5 à 8, caractérisé en ce que la fréquence d'échantillonnage (Fe) et la fréquence intermédiaire (pulsation $\omega_0$) sont choisies afin que le rapport $\omega_0$/Fe soit un multiple impair de $\pi$/2 de sorte que la variation de phase due à la porteuse entre deux échantillons soit un multiple impair de $\pi$/2, ladite fréquence d'échantillonnage (Fe) étant en outre choisie très supérieure à la fréquence symbole du signal reçu en entrée, de sorte qu'entre deux échantillons la contribution de la modulation de la phase de la porteuse par le flux de données est négligeable devant $\pi$/2.

10. Dispositif (3, 4, 5) selon l'une quelconque des revendications 5 à 8, caractérisé en ce que la fréquence d'échantillonnage (Fe) et la fréquence intermédiaire (pulsation $\omega_0$) sont choisies afin que le rapport $\omega_0$/Fe soit un multiple impair de $\pi$/2, ladite fréquence d'échantillonnage (Fe) étant en outre choisie très supérieure à la fréquence symbole du signal reçu en entrée, de sorte que l'enveloppe dudit signal reçu varie lentement entre deux échantillons.

**Patentansprüche**

1. Verfahren zur automatischen Verstärkungsregelung eines digitalen Verstärkers (1), insbesondere eines digitalen Verstärkers mit Mehrfachzugang und Zeitmultiplexierung (TDMA), der Verstärkungsmittel mit regelbarem Verstärkungsgrad (2) besitzt und ein Eingangssignal (e(t)) empfängt, dadurch gekennzeichnet, daß es folgende Schritte enthält:

- eine Tastung des Ausgangssignals s(t)) der Verstärkungsmittel (2) mit einer vorbestimmten Tastfrequenz,
- eine Verarbeitung der erhaltenen Tastproben, bei der für jede Tastprobe ein Vergleich des Absolutwerts dieser Tastprobe mit einem vorbestimmten oberen Schwellwert (SMAX) und einem vorbestimmten unteren Schwellwert (SMIN) erfolgt, denen ein größerer Bereich [-SMAX, +SMAX] und ein kleinerer Bereich [-SMIN, +SMIN] zugeordnet ist,
- und eine Nachregelung des Verstärkungsgrads (G) der Verstärkungsmittel (2) am Ende jeder Verarbeitung einer Tastprobe derart, daß:

  * der Verstärkungsgrad (G) um einen vorbestimmten Grad abgesenkt wird, wenn eine Tastprobe (E2) außerhalb des größeren Bereichs [-SMAX, +SMAX] liegt,
  * der Verstärkungsgrad (G) um einen bestimmten Betrag angehoben wird, wenn eine vorbestimmten Anzahl von aufeinanderfolgenden Tastproben (F0, F1; F4, F5; F8, F9) in dem kleineren Bereich [-SMIN, +SMIN] liegt.

2. Verfahren nach Anspruch 1, dadurch gekennzeichnet, daß jede Tastprobe mit vier Schwellwerten verglichen wird, und zwar einem oberen Schwellwert und einem unteren Schwellwert und ihren jeweiligen negativen Werten.

3. Verfahren nach Anspruch 1, dadurch gekennzeichnet, daß der Absolutwert jeder Tastprobe bestimmt wird und dann mit dem oberen und dem unteren Schwellwert verglichen wird.

4. Verfahren nach einem beliebigen der Ansprüche 1 bis 3, dadurch gekennzeichnet, daß die vorbestimmte Anzahl von aufeinanderfolgenden Tastproben, die in dem kleineren Bereich [-SMIN, +SMIN] liegt und zu einer Verstärkungsgrad-Anhebung führt, den Wert 2 hat.

5. Vorrichtung (3, 4, 5) zur Durchführung des Verfahrens nach einem beliebigen der vorhergehenden Ansprüche und zur automatischen Verstärkungsregelung eines digitalen Empfängers (1), insbesondere eines digitalen Empfängers mit Mehrfachzugang und Zeitmultiplexierung (TDMA), wobei der Empfänger (1) Verstärkungsmittel (2) mit regelbarem Verstärkungsgrad aufweist, die ein Eingangssignal (e(t)) empfangen, dadurch gekennzeichnet, daß sie Mittel (5) zum Tasten des Ausgangssignals (s(t)) der Verstärkungsmittel (2) mit einer vorbestimmten Tastfrequenz (Fe), Mittel (4) zum Vergleich des Absolutwerts jeder erhaltenen Tastprobe mit einem oberen Schwellwert (SMAX) und einem unteren Schwellwert (SMIN) und zur Erzeugung der Schwellwert-Erfassungsinformationen sowie Mittel (3) zur Nachregelung des Verstärkungsgrads (G) der Verstärkungsmittel (2) aufweist, die mit den Vergleichsmitteln (4) in Richtung einer Verringerung des Verstärkungsgrads (G) um einen vorbestimmten Pegelbetrag zusammenwirken, sobald eine Tastprobe (E2) erfaßt wurde, die außerhalb des größeren Bereichs [-SMAX, +SMAX] liegt, und in Richtung einer Erhöhung des Verstärkungsgrads (G) um einen vorbestimmten Pegelbetrag, sobald eine vorbestimmten Anzahl von aufeinanderfolgenden Tastproben (F0, F1; F4, F5; F8, F9) sich in einem kleineren Bereich [-SMIN, +SMIN] befindet.

6. Vorrichtung (3, 4, 5) nach Anspruch 5, dadurch gekennzeichnet, daß der Schritt der Absenkung oder Anhebung des Verstärkungsgrads im wesentlichen 3 dB beträgt.

7. Vorrichtung (3, 4, 5) nach einem beliebigen der Ansprüche 5 oder 6, dadurch gekennzeichnet, daß der untere Schwellwert (SMIN) im wesentlichen 10 dB unter dem oberen Schwellwert (SMAX) liegt.

8. Vorrichtung (3, 4, 5) nach einem beliebigen der Ansprüche 5 bis 7, dadurch gekennzeichnet, daß der obere Schwellwert (SMAX) im wesentlichen 6 dB unter dem Sättigungspegel des Basisbandbereichs des Empfängers (1) liegt.

9. Vorrichtung (3, 4, 5) nach einem beliebigen der Ansprüche 5 bis 8, dadurch gekennzeichnet, daß die Tastfrequenz (Fe) und die Zwischenfrequenz (Kreisfrequenz $\omega_0$) so gewählt sind, daß das Verhältnis $\omega_0$/Fe ein ungeradzahliges Vielfaches von n/2 ist, so daß die Phasenschwankung aufgrund des Trägers zwischen zwei Tastproben ein ungeradzahliges Vielfaches von n/2 ist, und daß die Tastfrequenz (Fe) außerdem deutlich oberhalb der Symbolfrequenz des am Eingang empfangenen Signals liegt, so daß zwischen zwei Tastproben der Beitrag der Modulation der Phase des Trägers durch den Datenfluß gegenüber n/2 vernachlässigbar ist.

10. Vorrichtung (3, 4, 5) nach einem beliebigen der Ansprüche 5 bis 8, dadurch gekennzeichnet, daß die Tastfrequenz (Fe) und die Zwischenfrequenz (Kreisfrequenz $\omega_0$) so gewählt sind, daß das Verhältnis $\omega_0$/Fe ein ungeradzahliges Vielfaches von $\pi$/2 ist, und daß die Tastfrequenz (Fe) außerdem deutlich größer als die Symbolfrequenz des am Eingang empfangenen Signals ist, so daß die Hüllkurve des Empfangssignals langsam zwischen zwei Tastproben variiert.

**Claims**

1. Automatic gain control method for a digital receiver (1), especially a time division multiple access (TDMA) digital receiver, comprising variable gain amplifier means (2) receiving an input signal (e(t)), characterised in that it comprises the following steps:

   - sampling the output signal (s(t)) of said amplifier means (2) at a predetermined sampling frequency,
   - processing each sample obtained by comparing its absolute value with a predetermined maximum threshold (SMAX) and a predetermined minimum threshold (SMIN) respectively associated with a maximum range [-SMAX, +SMAX] and a minimum range [-SMIN, +SMIN], and
   - adjusting the gain (G) of the amplifier means (2) after processing each sample so that:

     * if a sample (E2) is outside the maximum range [-SMAX, +SMAX] the gain (G) is reduced by a predetermined amount;
     * if a predetermined number of successive samples (F0, F1; F4, F5; F8, F9) lie in the minimum range [-SMIN, +SMIN] the gain (G) is increased by a predetermined amount.

2. Method according to claim 1 characterised in that each sample is compared with four thresholds: a maximum threshold and a minimum threshold and their respective opposite values.

3. Method according to claim 1 characterised in that the absolute value of each sample is determined and then compared with the maximum threshold and the minimum threshold.

4. Method according to any one of claims 1 to 3 characterised in that the predetermined number of successive samples in the minimum range [-SMIN, +SMIN] for which the gain is increased is equal to 2.

5. Automatic gain control device (3, 4, 5) for a digital receiver (1), especially a time division multiple access (TDMA) digital receiver, said receiver (1) comprising variable gain amplifier means (2) receiving an input signal (e(t)), implementing the method according to any one of the preceding claims, characterised in that it comprises means (5) for sampling the output signal (s(t)) of said amplifier means (2) at a predetermined sampling frequency (Fe), means (4) for comparing the absolute value of each sample obtained with a maximum threshold (SMAX) and a minimum threshold (SMIN) and for generating threshold detection information, and means (3) for adjusting the gain (G) of the amplifier means (2), said adjustment means (3) cooperating with the comparator means (4) to reduce said gain (G) by a predetermined amount if a sample (E2) is detected outside a maximum range [-SMAX, +SMAX] and to increase said gain (G) by a predetermined amount if a predetermined number of successive samples (F0, F1; F4, F5; F8, F9) lie in a minimum range [-SMIN, +SMIN].

6. Device (3, 4, 5) according to claim 5 characterised in that the predetermined amounts by wnich the gain is reduced and increased are substantially equal to 3 dB.

7. Device (3, 4, 5) according to claim 5 or claim 6 characterised in that the minimum threshold (SMIN) is substantially 10 dB below the maximum threshold (SMAX).

8.  Device (3, 4, 5) according to any one of claims 5 to 7 characterised in that the maximum threshold (SMAX) is substantially 6 dB below the saturation level of the baseband part of the receiver (1).

9.  Device (3, 4, 5) according to any one of claims 5 to 8 characterised in that the sampling frequency (Fe) and the intermediate frequency (angular frequency $\omega_o$) are chosen so that the ratio $\omega_0/Fe$ is an odd multiple of $\pi/2$ so that the variation in phase due to the carrier between two samples is an odd multiple of $\pi/2$, said sampling frequency (Fe) being further chosen to be very much higher than the symbol frequency of the input signal received so that between two samples the contribution of the modulation of the phase of the carrier by the flow of data is negligible in comparison with $\pi/2$.

10. Device (3, 4, 5) according to any one of claims 5 to 8 characterised in that the sampling frequency (Fe) and the intermediate frequency (angular frequency $\omega_o$) are chosen so that the ratio $\omega_0/Fe$ is an odd multiple of $\pi/2$, said sampling frequency (Fe) being also chosen to be very much higher than the symbol frequency of the input signal received so that the envelope of said received signal varies slowly between two samples.

## FIG.1

| $\dfrac{A}{S_{MAX}}$ (dB) | PROBABILITE DE DEPASSEMENT D'UN ECHANTILLON | PROBABILITE D'AU MOINS UN DEPASSEMENT PARMI DEUX ECHANTILLONS SUCCESSIFS |
|:---:|:---:|:---:|
| 1 | 0,30 | 0,60 |
| 2 | 0,42 | 0,83 |
| 3 | 0,75 | 1,0 |
| 6 | 0,83 | 1,0 |
| 9 | 0,89 | 1,0 |
| 12 | 0,92 | 1,0 |
| 15 | 0,94 | 1,0 |
| 20 | 0,97 | 1,0 |

## FIG.3

FIG. 2A

FIG. 2B